# EUROPEAN PATENT APPLICATION

(11) **EP 2 519 027 A1**
(43) Date of publication of application: **31.10.2012**
(21) Application number: 10854347.1
(22) Date of filing: 17.11.2010
(51) Int. Cl.: H04R 1/10, H04R 3/00, H03K 17/78, H03K 17/94, G11C 7/16

(54) **METHOD FOR CONTROLLING MUSIC PLAYING AND MUSIC PLAYING TERMINAL**

(30) Priority: 07.07.2010 CN 201010228020
(71) Applicant: ZTE Corporation, Shenzhen, Guangdong 518057 (CN)
(72) Inventor: LIU, Chuan, Shenzhen Guangdong 518057 (CN)
(74) Representative: Jennings, Michael John
(86) International application number: PCT/CN2010/078816
(87) International publication number: WO 2012/003688

(57) **Abstract**

The invention discloses a music-playing control method and a music playing terminal. The method comprises the following steps: optical-proximity inductive sensors in the earphone sense there is an object within their effective induction ranges, and trigger the earphone to send control signals to a music playing terminal, wherein the control signals are used for indicating the optical-proximity inductive sensors that have sensed the objects; the music playing terminal determines the motion trail of the object within a preset time period according to the received control signals and the time of receiving the control signals and executes control instructions corresponding to the motion trail. Through the invention, the music-playing control becomes simple and convenient, and the user experience is improved.

## Description

### Technical field of the invention

The invention relates to communication field, and particularly relates to a music-playing control method and a music playing terminal.

### Background of the invention

At present, earphones used in MP3 players or mobile phones generally include two kinds: (1) earphones themselves have no music control function key, music-playing is controlled through operations on the terminals on MP3 players or mobile phones, and the terminals have to be taken out at each time of operation, therefore it is very cumbersome to use these earphones; (2) earphones have special music control keys, however, as these music-playing control keys are designed in small size, it is inconvenient to press these keys by hands, and false operation may be caused in some cases.

In related technologies, an inductive earphone that can sense whether the user wears earphone or not is provided, that is, pressure or temperature sensors are arranged on the earplug of the earphone, after the user plugs in or takes out the earplug of the earphone, the sensors feed back the states to the earphone, and the music player is controlled to play or stop according to the fed state.

The inventors of the present invention note that the inductive earphone in the related technologies could only sense whether the user wears the earphone or not to control the play or stop of music, music-playing control is fairly limited and user experience is relatively low.

### Summary of the invention

The main purpose of the invention is to provide a music-playing control solution, to at least solve the problem that the music-playing control of the inductive earphone in the related technologies is fairly limited.

In order to achieve the above purpose, according to one aspect of the invention, a music-playing control method is provided.

According to the invention, the music-playing control method comprises the following steps: optical-proximity inductive sensors in the earphone sense there are objects within their effective induction ranges, and trigger the earphone to send control signals to a music playing terminal, wherein the control signals are used for indicating the optical-proximity inductive sensors that sense the objects; the music playing terminal determines the motion trail of the object within a preset time period according to the received control signals and the time of receiving the control signals and executes control instructions corresponding to the motion trails.

Further, the step that the music playing terminal determines the motion trail of the object within the preset time period according to the received control signals and the time of receiving the control signals comprises the following steps: the music playing terminal determines whether the optical-proximity inductive sensors are located in the left earphone or right earphone according to the control signals; the music playing terminal determines the motion trail of the object according to the time of receiving the control signals within the preset time period and the position of the optical-proximity inductive sensors that trigger the control signals.

Further, motion trails comprises one of the following cases: objects move to another optical-proximity inductive sensor in the left earphone from one optical-proximity inductive sensor in the left earphone, objects move to another optical-proximity inductive sensor in the right earphone from one optical-proximity inductive sensor in the right earphone, objects stay in the effective induction range of one optical-proximity inductive sensor for a long time, and objects stay in the effective induction ranges of multiple optical-proximity inductive sensors for a long time.

Further, the step that the music playing terminal executes control instructions corresponding to motion trails comprises one of the following steps: when the motion trail of objects is that objects move to another optical-proximity inductive sensor in the left earphone from one optical-proximity inductive sensor in the left earphone, the control instruction to be executed by the music playing terminal is to switch music or adjust volume; when the motion trail of objects is that objects move to another optical-proximity inductive sensor in the right earphone from one optical-proximity inductive sensor in the right earphone, the control instruction to be executed by the music playing terminal is to switch music or adjust volume; when the motion trail of objects is that objects stay in the effective induction range of one optical-proximity inductive sensor for a long time, if the music playing terminal is in a music stop state, the control instruction to be executed by the music playing terminal is to play music, if the music playing terminal is in a music playing state, the control instruction to be executed by the music playing terminal is to stop playing music; when the motion trail of objects is that objects stay in the effective induction ranges of two optical-proximity inductive sensors for a long time, if the music playing terminal is in a lock state, the control instruction to be executed by the music playing terminal is to unlock the music playing terminal, if the music playing terminal is in an unlock state, the control instruction to be executed by the music playing terminal is to lock the music playing terminal.

Further, control instructions comprise at least one of the following instructions: playing the next song, playing the last song, turn volume up, turn volume down, playing music, stop playinging music, lock and unlock.

Further, after executing control instructions corresponding to motion trails, the music playing terminal also sends an operation end prompt tone to the earphone.

In order to achieve the above purpose, according to another aspect of the invention, a music playing terminal is also provided.

According to the invention, the music playing terminal comprises an earphone; the earphone comprises: optical-proximity inductive sensors used for sensing an object within their effective induction ranges and triggering the earphone to send control signals to an identification module after sensing the object, wherein the control signals are used for indicating the optical-proximity inductive sensors that have sensed the object; an identification module for determining the motion trail of the object within a preset time period according to the received control signals and the time of receiving the control signals; and an execution module for executing control instructions corresponding to the motion trail.

Further, the earphone comprises a left earphone and a right earphone; two optical-proximity inductive sensors are arranged in the left earphone and the right earphone, respectively, wherein two optical-proximity inductive sensors and the center of the left or right earphone are on a same straight line.

Further, the identification module is also used for determining whether the optical-proximity inductive sensors are located in the left earphone or right earphone according to the control signals, and determining motion trails of the objects according to the time of receiving the control signals within the preset time period and the position of the optical-proximity inductive sensors that trigger the control signals.

Further, two optical-proximity inductive sensors in the left or right earphone can rotate by using the center line as axis.

Through the invention, the optical-proximity inductive control technology is employed and the problem that music-playing control of inductive earphones in the related technologies is fairly single is solved, such that music-playing control becomes simple and convenient, and the user experience is improved.

### Brief description of the drawings

Drawings to be described below are provided for further understanding of the invention as one part of the application, the embodiments of the invention and description thereof are used for explaining the invention, to which the invention shall not be improperly limited. In the drawings:
Fig. 1 shows a flowchart of a music playing control method according to one embodiment of the invention;
Fig. 2 shows a structural diagram of a music playing terminal according to one embodiment of the invention;
Fig. 3 shows a structural diagram of a music playing terminal according to a preferred embodiment of the invention;
Fig. 4 shows a structural diagram of a gesture music playing control earphone according to one embodiment of the invention;
Fig. 5 shows a schematic diagram of a gesture music control module according to one embodiment of the invention;
Fig. 6 shows a flowchart of implementing control and identification functions of the music playing terminal according to one embodiment of the invention;
Fig. 7 shows a diagram of meanings of control gestures according to one embodiment of the invention.

### Detailed description of the invention

The invention will be described in detail below by reference to drawings and in combination with embodiments. It should be noted that embodiments in the application and features in the embodiments could be combined together if not conflict.

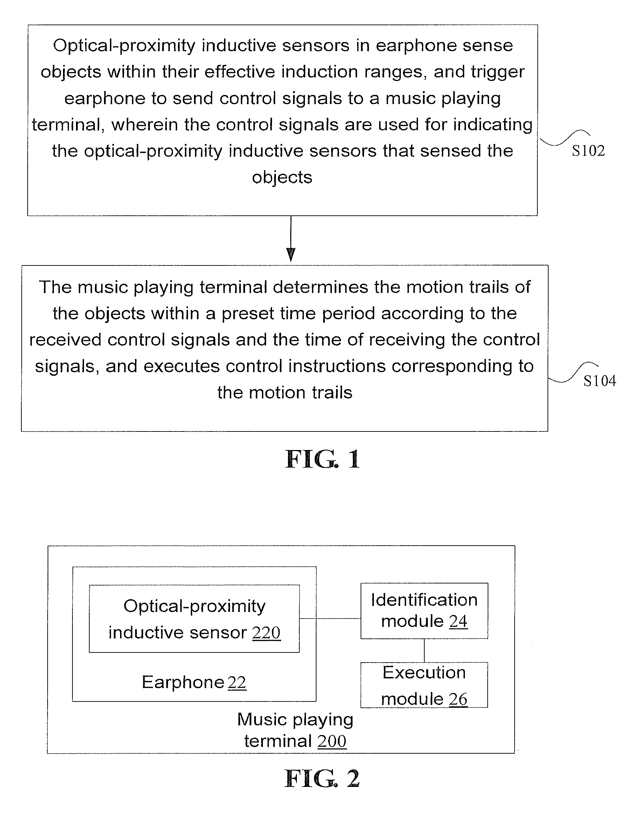

Fig. 1 shows a flowchart of a music-playing control method according to one embodiment of the invention. As shown in Fig. 1, the method comprises the following steps:

S102: Optical-proximity inductive sensors in the earphone sense there are objects within their effective induction ranges, and trigger the earphone to send control signals to a music playing terminal to indicate the optical-proximity inductive sensors that have sensed the objects;

S104: The music playing terminal determines the motion trails of the objects within a preset time period according to the received control signals and the time of receiving the control signals and executes control instructions corresponding to the motion trails.

For example, certain rules, which indicate the corresponding relationships between motion trails of objects and control instructions, can be set in the music playing terminal in advance.

According to some embodiments of the invention, the optical-proximity inductive control technology is employed to solve the problem that music-playing control of inductive earphones in the related technologies is fairly limited, such that music-playing control becomes simple and convenient, and the user experience is improved.

Preferably, in S104, the music playing terminal determines whether the optical-proximity inductive sensors are located in the left earphone or right earphone according to the control signals; the music playing terminal determines motion trails of the objects according to the time of receiving the control signals within the preset time period and the position of the optical-proximity inductive sensors that trigger the control signals. The method is easy and feasible.

Preferably, motion trails comprise one of the following cases: objects move to another optical-proximity inductive sensor in the left earphone from one optical-proximity inductive sensor in the left earphone, objects move to another optical-proximity inductive sensor in the right earphone from one optical-proximity inductive sensor in the right earphone, objects stay in the effective induction range of one side of optical-proximity inductive sensor (for example, there are two optical-proximity inductive sensors at one side of the earphone) for a long time, and objects stay in the effective induction ranges of more than one optical-proximity inductive sensor (for example, there are two optical-proximity inductive sensors in the left earphone and the right earphone, respectively, that is, there are total four two optical-proximity inductive sensors at the two sides of the earphone) for a long time. The method enables the system to identify motion trails of the objects effectively to execute control instructions according to the predetermined rule.

For example, the predetermined rules can be corresponding relationships between motion trails of objects and control instructions set when the music playing terminal was manufactured by the manufacturer.

Further, in S104, the step that the music playing terminal executes control instructions corresponding to motion trails comprises one of the following steps. When the motion trail of objects is that objects move to another optical-proximity inductive sensor in the left earphone from one optical-proximity inductive sensor in the left earphone, the control instruction to be executed by the music playing terminal is to switch music or adjust volume. When the motion trail of objects is that objects move to another optical-proximity inductive sensor in the right earphone from one optical-proximity inductive sensor in the right earphone, the control instruction to be executed by the music playing terminal is to switch music or adjust volume. When the motion trail of objects is that objects stay in the effective induction range of only one optical-proximity inductive sensor for a long time, if the music playing terminal is in a music stop state, the control instruction to be executed by the music playing terminal is to play music; and if the music playing terminal is in a music playing state, the control instruction to be executed by the music playing terminal is to stop playing music. When the motion trail of objects is that objects stay in the effective induction ranges of two optical-proximity inductive sensors for a long time, if the music playing terminal is in a lock state, the control instruction to be executed by the music playing terminal is to unlock the music playing terminal; and if the music playing terminal is in an unlock state, the control instruction to be executed by the music playing terminal is to lock the music playing terminal.

In the preferred embodiment, by corresponding motion trails of objects identified by the system to specific playing control instructions of the music playing terminal, application of optical-proximity inductive sensor technology can achieve control of music playing, and the processing capacity of the system is improved.

For example, when the music playing terminal determines that the motion trail of objects is that objects move to another optical-proximity inductive sensor in the left earphone from one optical-proximity inductive sensor in the left earphone, the control instruction to be executed by the music playing terminal is to switch music, then when the motion trail of objects is that objects move to another optical-proximity inductive sensor in the right earphone from one optical-proximity inductive sensor in the right earphone, the control instruction to be executed by the music playing terminal is to adjust volume. During specific implementation, control instruction of the left earphone and control instruction of the right earphone indicate different operations in the predetermined rules.

Preferably, control instructions comprise at least one of the following instructions: play the next song, play the last song, turn volume up, turn volume down, play music, stop playing music, lock and unlock. The method is easy and feasible.

Preferably, after S104, the music playing terminal can send an operation end prompt tone to the earphone. The method can notify the user in time that the execution of music-playing control instruction is finished; therefore, the user experience is improved.

Fig. 2 shows a structural diagram of a music playing terminal according to the embodiment of the invention, as shown in Fig. 2, the music playing terminal 200 comprises an earphone 22, an identification module 24 and an execution module 26, wherein, the earphone 22 comprises: optical-proximity inductive sensors 220 used for sensing objects within their effective induction ranges and triggering the earphone to send control signals to the identification module 24 after sensing objects to indicate the optical-proximity inductive sensors 220 that sense the objects; an identification module 24, coupled to the optical-proximity inductive sensors 220, and used for determining the motion trails of the objects within a preset time period according to the received control signals and the time of receiving the control signals; and an execution module 26, coupled to the identification module 24 and used for executing control instructions corresponding to the motion trails.

Through the invention, the optical-proximity inductive control technology is employed and the problem that music-playing control of inductive earphones in the related technologies is fairly limited is solved, such that music-playing control becomes simple and convenient, and the user experience is improved.

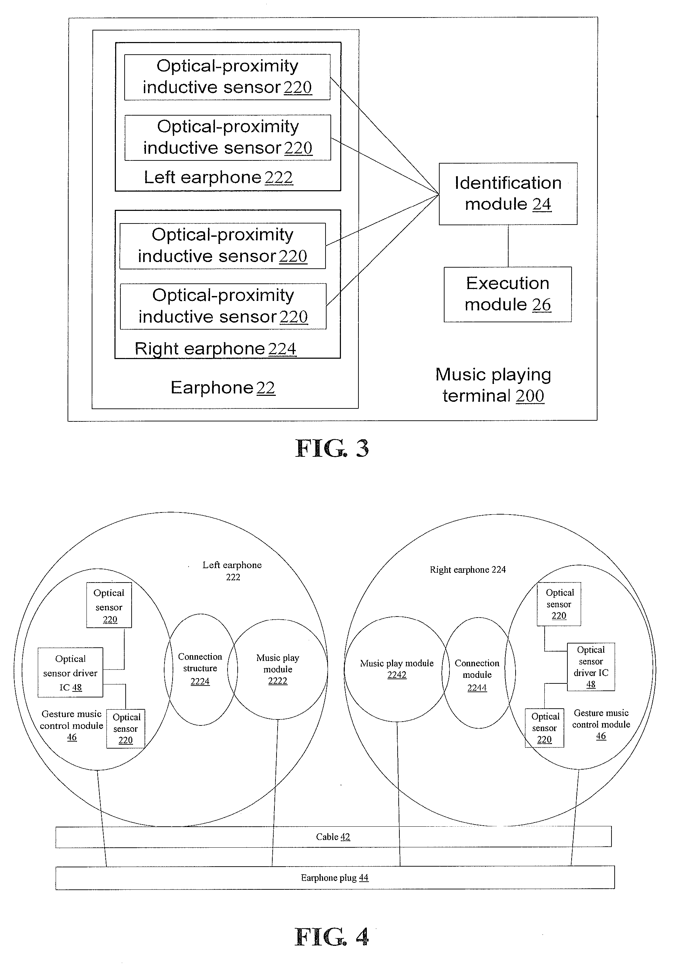

Fig. 3 shows a structural diagram of the music playing terminal according to a preferred embodiment of the invention, as shown in Fig. 3, the earphone 22 comprises a left earphone 222 and a right earphone 224, two optical-proximity inductive sensors 220 are arranged in the left earphone 222 and the right earphone 224, respectively, wherein two optical-proximity inductive sensors 220 and the center of the left earphone 222 or right earphone 224 are on a same straight line.

Preferably, the identification module 24 is also used for determining whether the optical-proximity inductive sensors 220 are located in the left earphone 222 or right earphone 224 according to the control signals, and determining motion trails of the objects according to the time of receiving the control signals within the preset time period and the position of the optical-proximity inductive sensors 220 that trigger the control signals.

Preferably, two optical-proximity inductive sensors 220 in the left earphone 222 or right earphone 224 can rotate by using the center line as axis.

The implementation process of the embodiments of the invention will be described in detail below with references to examples.

### Example 1

Fig. 4 shows a structural diagram of a gesture music-playing control earphone according to example 1 of the invention, as shown in Fig. 4, the earphone 22 comprises a left earphone 222, a right earphone 224, a cable 42 and an earphone plug 44. Wherein, gesture music control modules 46 are added on the left earphone 222 and the right earphone 224. Besides the basic function of playing music, the earphone 22 also can achieve control of volume, song switching and pause/play by the gesture music control modules 46.

During specific implementation, gesture music control modules 46 on the left earphone 222 and the right earphone 224 are cores of the music control earphone, mechanical keys are not needed on the music control earphone any more. Besides, one optical-proximity inductive sensor 220 is arranged at the edges in the up and down directions of the gesture music control modules 46, respectively, and the two optical-proximity inductive sensors 220 are controlled by an optical sensor driver integrated circuit (IC) 48. When objects reach the effective induction distances of the optical-proximity inductive sensors 220, the optical-proximity inductive sensors 220 send signals to the driver chips to indicate that there are objects, the driver IC 48 converts information to control signals and sends them to the terminal by a control bus. It should be noted that when the user does not need play operation, the earphone can be locked by the gesture music control modules 46 to avoid false triggering.

During specific implementing, the cable 42 also should have a control bus for transmitting control signals besides common audio signal line of earphone. The earphone plug 44 can be used for connecting the earphone and the music playing terminal.

Preferably, the left earphone 222 and the right earphone 224 can be connected with the earphone plug 44 through the cable 42, respectively, audio signal parts of the left earphone 222 and the right earphone 224 are transmitted by the audio line on the cable 42 separately, and control signals are transmitted by the control bus on the cable 42 and finally connected to the music playing terminal through the earphone plug 44.

Implementation of functions of the gesture music-playing control earphone comprises the following steps:

S402: The earphone plug 44 is inserted into the earphone jack of the music playing terminal and the music-playing operation interface is opened.

S404: The gesture music control modules 46 of the earphone wait for operation gesture signals. When there is an operation gesture before the optical-proximity inductive sensors 220, the gesture music control modules 46 report the position of the trigged sensors to the music playing terminal by the control bus according to the time sequence of triggering.

S406: After receiving the triggering information of the sensors 220, the music playing terminal judges the operation meaning of the triggering information according to the position of the trigged sensors 220 and the time interval information, implements corresponding music-playing operation, and sends a prompt tone through the earphone to notify the operator that the gesture operation has been executed.

By adding optical-proximity inductive sensors 220 on the earphone, the embodiment achieves identification of gestures in different directions and reaches the purpose of music-playing control. As no key-press operation on the controller of the earphone is needed, the operation is more convenient and fast. Besides, gesture control makes music control more fun, which is a strong attraction to users who like listening to music.

### Example 2

As shown in Fig. 4, the hardware of the gesture music-playing control earphone 22 mainly consists of four parts: a left earphone 222, a right earphone 224, a cable 42 and an earphone plug 44.

During specific implementation, the left earphone 222 and the right earphone 224 can be similar in terms of components; the only difference is that the two earphones have different music-playing control, which is distinguished by software. Wherein, the left earphone 222 mainly consists of gesture music control modules 46, a music playing module 2222 and a connection structure 2224.

The gesture music control modules 46 consist of two optical-proximity inductive sensors 220 located at the edges in two directions and a sensor driver IC 48; the music playing module 2222 is the same as that in traditional earphones; the connection structure 2224 is used for connecting the gesture music control modules 46 and the music playing module 2222, it is able to rotate according to demands of the user and change the angle between the sensors and the horizon to fit demands of gesture directions of different user groups.

Similarly, the right earphone 224 consists of gesture music control modules 46, a music playing module 2242 and a connection structure 2244, wherein the music playing module 2242 and the connection structure 2244 are the same as the music playing module 2222 and the connection structure 2224, correspondingly. The gesture music control modules 46 in the left earphone 222 and the right earphone 224 are connected to the earphone plug 44 through the control bus in the cable 42, respectively; the music playing module 2242 and the connection structure 2244 are connected to the earphone plug 44 through the audio signal line in the cable 42, respectively.

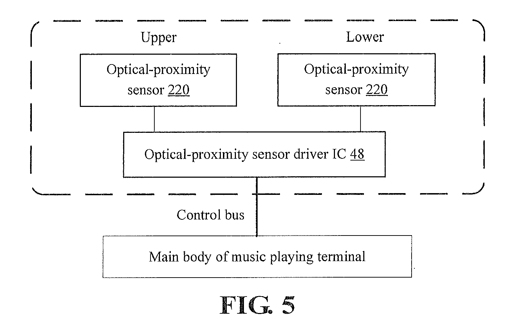

Fig. 5 shows a schematic diagram of a gesture music control module according to Example 2 of the invention, as shown in Fig. 5, the optical-proximity sensors 220 are connected with the optical sensor driver IC 48, the optical-proximity sensors 220 are trigged after there are gestures approaching. They send signals to the optical sensor driver IC 48, and the optical sensor driver IC 48 in turn sends the position information of the triggered sensors 220 to the main body of the music playing terminal through the control bus according to the time interval. During specific implementation, two optical-proximity sensors 220 can be located at the upper edge and lower edge of the gesture music control modules 46, respectively, and on the same straight line with the center of the earphone.

In additional, in order to achieve complete music-playing control by gestures, it is also needed that the music playing terminal can identify control signals from the gesture control earphone.

It is thus clear that in the music playing terminal according to one embodiment of the invention, a control module (namely, gesture music control modules 46) is added on the left earphone and the right earphone of the earphone, respectively, two optical-proximity inductive sensors 220 are arranged on each module, therefore the user can achieve music-playing control by changing direction of gestures in front of the control modules.

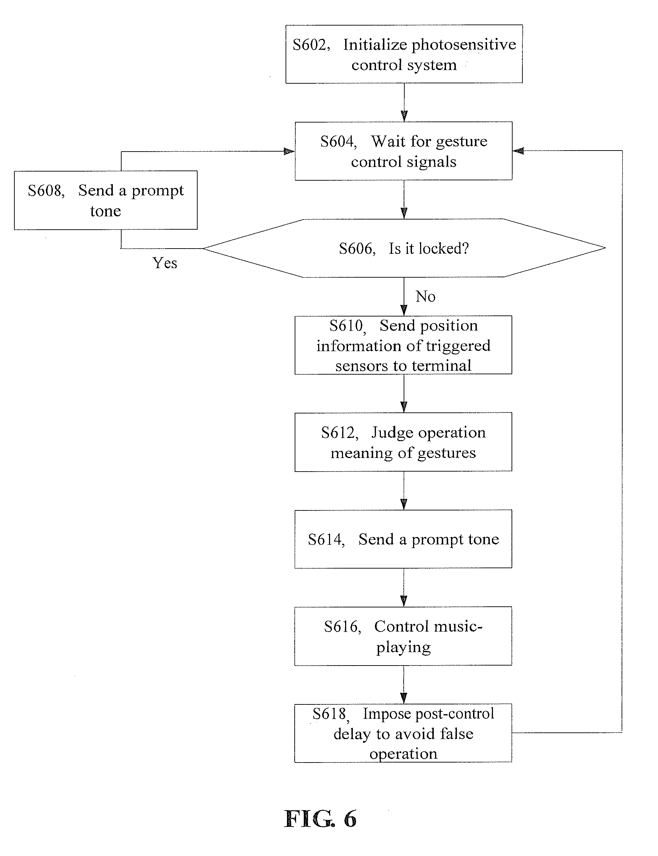

Fig. 6 shows a flowchart of implementing control and identification functions of the music playing terminal according to Example 2 of the invention, as shown in Fig. 6, the whole function implementing flow is as follows:

S602: By the system, initializing the photosensitive control system.

S604: After initializing the whole function module, waiting for sending of gestures; reporting to the terminal when sensors on the gesture music control module receive control gestures.

S606: Inquiring whether the earphone is in control lock state, if so, entering the S608; if not, entering the S610.

S608: Sending a prompt tone, and continue to wait for gestures without executing the current gesture operation.

S610: Sending the position information of the triggered sensors to the terminal.

S612: By the terminal, judging the control meaning (namely, control instructions, for example, triggering of sensors on the left earphone 222 means volume control, triggering of sensors on the right earphone 224 means song changing. , It is also needed to determine whether to turn up or down volume or change to the last or next song) of the gesture to be executed at this moment according to the position information of the triggered sensors from the function module and the time sequence.

S614: Sending prompt tones by the earphone. For example, prompt tone of "turn up volume" is "di", prompt tone of "turn down volume" is "da", prompt tone of "next song" is "didi", and prompt tone of "last song" is "dada". Therefore, the user can obtain prompts whether operations are executed correctly.

S616: Executing operations of control instructions and controlling music-playing.

S618: After gesture operations are executed, there can be 1-2s time delay. During this period, operations will not be executed even the sensors are triggered to avoid false operation due to back of gestures.

### Example 3

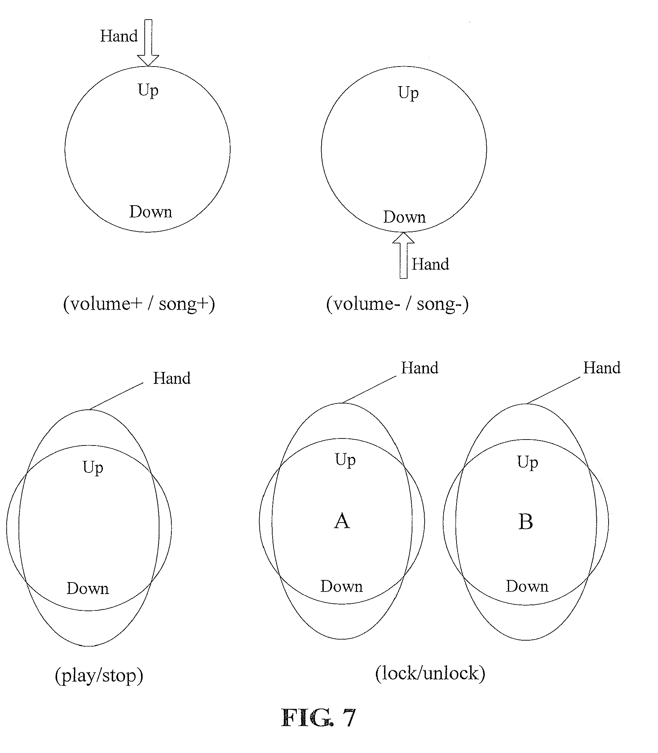

Fig. 7 shows a diagram of meanings of control gestures according to Example 3 of the invention, as shown in Fig. 7, the judgment rules of meanings of gestures can be: when the motion direction of one gesture is cross before the gesture music control modules 46 from up to down, if the gesture stops immediately after covering the upper optical-proximity inductive sensor 220, the driver IC 48 will only report the position value of one sensor 220, the terminal can directly judge that control to be executed is to turn up volume by one level (or, switch to the next song); but when one gesture passes through the upper sensor 220 and then passes through the lower sensor 220 quickly, the driver IC 48 will report the position values of the two sensors 220 in turn, but the time interval of reporting the two position values is very short (for example, not more than 500ms), the terminal can take the time interval as basis of judgment, ignore the position value reporting signal after a time interval (for example, 500ms) from the first position value reporting signal, only execute the control information corresponding to the first reported position value. The judgment principle in the other direction is similar.

During specific implementation, when it is necessary to carry out play and stop control, the user can put his hand on one gesture music control module 46 in the left earphone 222 or right earphone 224 for more than 2 seconds, such that the music playing terminal detects that two sensors 220 are triggered for a long time. At this time, if music is being played, the gesture means "stop"; if music is not played, the gesture means "play".

During specific implementation, when it is necessary to carry out lock and unlock control, the user can put his two hands on two gesture music control modules 46 in the left earphone 222 and right earphone 224 for more than 2 seconds, such that the music playing terminal detects that four sensors 220 are triggered for a long time. At this time, if the music playing terminal is in lock state, the gesture means "unlock"; if it is in unlock state, the gesture means "lock".

In conclusion, the embodiment of the invention utilizes optical-proximity inductive control technology, and achieves music-playing control by changing direction of gestures before the gesture music control modules 46. The invention not only controls music-playing, but also controls volume and music switching; the implementing of music-playing control becomes quite convenient; and the user experience is improved.

Obviously, technicians in the field should understand that the above modules or steps of the invention could be achieved through general calculating devices, they can be concentrated in a single calculating device or distributed in a network formed by multiple calculating devices, optionally, they can be achieved by program codes that can be executed by calculating devices, thus, they can be stored in storage devices to be executed by calculating devices, and under certain situation, the shown or described steps can be executed according to an order different from the above order, or they can be achieved by respectively making them into many integrated circuit modules or by making multiple modules or steps among them into a single integrated circuit module. In this way, the invention is not limited to combinations of any specific hardware and software.

The above contents only describe preferred embodiments of the invention. It is not intended that the invention should be limited to the above description. For technicians in the field, the invention can have various alterations and changes. Any modification, equivalent replacement and improvement within the spirit and principle of the invention should be included in the protection scope of the invention.

## Claims

1. A music-playing control method, **characterized by** comprising:
using optical-proximity inductive sensors in an earphone to sense an object within effective induction ranges of the inductive sensors, and to trigger the earphone to send control signals to a music playing terminal, wherein the control signals are used for indicating the optical-proximity inductive sensors that have sensed the object;
using the music playing terminal to determine a motion trail of the object within a preset time period according to the received control signals and a time of receiving the control signals and to execute control instructions corresponding to the motion trail.

2. The method according to claim 1, **characterized in that** using the music playing terminal to determine a motion trail of the object within a preset time period according to the received control signals and time of receiving the control signals comprises
using the music playing terminal to:
determine whether the optical-proximity inductive sensors are located in a left earphone or right earphone according to the control signals;
determine the motion trail of the object according to the time of receiving the control signals within the preset time period and a position of the optical-proximity inductive sensors that trigger the control signals.

3. The method according to claim 2, **characterized in that** the motion trail comprises one of the following cases: the object moving from one optical-proximity inductive sensor in the left earphone to another optical-proximity inductive sensor in the left earphone, the object moving from one optical-proximity inductive sensor in the right earphone to another optical-proximity inductive sensor in the right earphone, the object staying in the effective induction range of one optical-proximity inductive sensor for a long time, and the object staying in the effective induction ranges of multiple optical-proximity inductive sensors for a long time.

4. The method according to claim 2, **characterized in that** using the music playing terminal to execute control instructions corresponding to a motion trail comprises one of the following steps:
when the motion trail of the object is the object moving from one optical-proximity inductive sensor in the left earphone to another optical-proximity inductive sensor in the left earphone, switching music or adjusting volume;
when the motion trail of the object is the object moving from one optical-proximity inductive sensor in the right earphone to another optical-proximity inductive sensor in the right earphone, switching music or adjusting volume;
when the motion trail of the object is the object staying in the effective induction range of one optical-proximity inductive sensor for a long time: if the music playing terminal is in a music stop state, playing music; if the music playing terminal is in a music play state, stop playing music;
when the motion trail of the object is the object stay in the effective induction ranges of two optical-proximity inductive sensors for a long time: if the music playing terminal is in a lock state, unlocking the music playing terminal; if the music playing terminal is in an unlock state, locking the music playing terminal.

5. The method according to claim 1, **characterized in that** control instructions comprise at least one of the following instructions:
play the next song, play the last song, turn volume up, turn volume down, play music, stop playing music, lock and unlock.

6. The method according to any one of claims 1 to 5, **characterized in that** the music playing terminal sends an operation end prompt tone to the earphone after the music playing terminal executes control instructions corresponding to the motion trail.

7. A music playing terminal, **characterized by** comprising:
an earphone, wherein the earphone comprises optical-proximity inductive sensors used for sensing objects within their effective induction ranges and triggering the earphone to send control signals to an identification module after sensing an object, wherein the control signals are used for indicating the optical-proximity inductive sensors that have sensed the object;
an identification module for determining a motion trail of the object within a preset time period according to the received control signals and a time of receiving the control signals; and
an execution module for executing control instructions corresponding to the motion trail.

8. The terminal according to claim 7, **characterized in that** the earphone comprises a left earphone and a right earphone; two optical-proximity inductive sensors are arranged in the left earphone and the right earphone, respectively, wherein the two optical-proximity inductive sensors and the centre of the left or right earphone are on a same straight line.

9. The terminal according to claim 8, **characterized in that** the identification module is also used for determining whether the optical-proximity inductive sensors are located in the left earphone or right earphone according to the control signals, and determining the motion trail of the object according to the time of receiving the control signals within the preset time period and the position of the optical-proximity inductive sensors that trigger the control signals.

10. The terminal according to claim 8, **characterized in that** two optical-proximity inductive sensors in the left or right earphone can rotate by using the center line as axis.
